# EUROPÄISCHE PATENTSCHRIFT

(11) **EP 1 308 193 B1**
(45) Veröffentlichungstag und Bekanntmachung des Hinweises auf die Patenterteilung: **16.03.2005**
(21) Anmeldenummer: 02022514.0
(22) Anmeldetag: 07.10.2002
(51) Int. Cl.: B01D 9/02

(54) **Verfahren zur Herstellung von Kristallen aus in Lösungsmitteln gelösten Feststoffen**
Process for producing crystals from solutions containing dissolved solids
Procédé pour la production de cristaux à partir de solutions contenant des solides dissous

(30) Priorität: 09.10.2001 DE 10149814
(43) Veröffentlichungstag der Anmeldung: 07.05.2003
(73) Patentinhaber: Fraunhofer-Gesellschaft zur Förderung der angewandten Forschung e.V., 80686 München (DE)
(72) Erfinder: Teipel, Ulrich, Dr.-Ing., 76327 Pfinztal (DE); Leisinger, Karlfred, 76149 Karlsruhe (DE); Förter-Barth, Ulrich, Dr.-Ing., 76199 Karlsruhe (DE)

(56) Entgegenhaltungen:
- DE-A- 2 722 636
- DE-A- 4 103 575
- DE-A- 4 125 463
- US-A- 4 551 196
- US-A- 5 712 511

## Beschreibung

Die Erfindung betrifft ein Verfahren zur Herstellung von regelmäßigen kristallinen Feststoffpartikeln mit keinen oder nur geringen Kristalldefekten, wie Fehlstellen und dergleichen, aus wenigstens einem in einem Lösungsmittel gelösten Feststoff mit positiver bzw. negativer Löslichkeit, indem die Lösung unter Bildung des Feststoffkristallisates bis unterhalb ihrer Sättigungstemperatur abgekühlt bzw. bis oberhalb ihrer Sättigungstemperatur erhitzt wird. Die Erfindung betrifft ferner eine Vorrichtung zur Durchführung eines solchen Verfahrens mit einem im wesentlichen zylindrischen Kristallisationsbehälter zur Aufnahme der Lösung mit einem hierzu koaxial unter Bildung eines radialen Ringraums angeordneten und relativ zu diesem rotierbaren, im wesentlichen zylindrischen Innenteil, wobei der Kristallisationsbehälter und/oder das Innenteil temperierbar ist/sind.

Die Kristallisation ist ein bekanntes thermisches Gewinnungs- oder Trennverfahren, wobei eine Komponente eines aus wenigstens zwei Komponenten bestehenden homogenen Systems, beispielsweise einer Lösung, einer Schmelze oder eines Gasgemisches, unter Bildung einer festen Phase abgetrennt wird. Bei der Kristallisation eines oder mehrerer Feststoffe aus einer Lösung mit molekulardisperser Verteilung der Feststoffe in einem Lösungsmittel wird die Lösung in der Regel durch Kühlen (Kühlungskristallisation), Verdampfen des Lösungsmittels (Verdampfungskristallisation) oder Kombination beider Varianten übersättigt, wobei durch Abbau dieser Übersättigung der Feststoff als Kristallisat anfällt, das mechanisch von der Restlösung abtrennbar ist. Die Übersättigung kann durch Unterdruck (Vakuumkristallisation), Aussalzen, Ausfällen, gegebenenfalls durch Zugabe von Impfkeimen, oder Zuführung von Rührenergie (Agitation) zusätzlich unterstützt werden. Insbesondere die Kristallisation aus Lösungen findet vielfältig Verwendung zur Reinigung oder Trennung von Stoffgemischen, zur Aufkonzentrierung von Lösungen oder zur Herstellung von Partikeln hoher Reinheit oder bestimmter Partikelform oder zur Verringerung von Kristallfehlstellen bzw. zur Modifikation der kristallinen Phase.

Bei der Herstellung thermisch empfindlicher kristalliner Feststoffe, wie Treib-, Explosivstoffe und Oxidatoren, Pharmazeutika, Hormonen oder dergleichen, kommt vornehmlich die Kühlungs- oder Heizkristallisation zum Einsatz, um die thermische Beeinträchtigung des Kristallisates gegenüber der Verdampfungskristallisation möglichst gering zu halten. Während die Kühlungskristallisation zur Herstellung von Kristallen aus Feststoffen mit positiver Löslichkeit eingesetzt werden kann, ist die Heizkristallisation zur Herstellung von Kristallen mit negativer Löslichkeit geeignet. Die meisten Feststoffe weisen eine positive Löslichkeit auf, was bedeutet, daß das Löslichkeitsprodukt einer bei einer bestimmten Temperatur gesättigten Lösung durch Absenken dieser Temperatur unter Bildung des Feststoffkristallisates überschritten wird. Ferner sind aus gelöstem Feststoff und Lösungsmittel bestehende Stoffsysteme mit negativer Löslichkeit bekannt, bei denen das Löslichkeitsprodukt einer bei einer bestimmten Temperatur gesättigten Lösung durch Erhöhen dieser Temperatur unter Bildung des Feststoffkristallisates überschritten wird. Die Kristallbildung wird bei Feststoffen mit positiver Löslichkeit im metastabilen Bereich der Lösung unterhalb ihrer Sättigungstemperatur, im Falle von Feststoffen mit negativer Löslichkeit im metastabilen Bereich der Lösung oberhalb ihrer Sättigungstemperatur ausgelöst.

Diese Kristallisationsverfahren eignen sich grundsätzlich für alle diejenigen aus Lösungsmittel und gelösten Feststoff bestehenden Systeme, welche eine verhältnismäßig starke Abhängigkeit der Löslichkeit des Feststoffes von der Temperatur des jeweiligen Lösungsmittels aufweisen. Die Qualität der Kristalle hinsichtlich Partikelgrößenverteilung, Reproduzierbarkeit, Kristalldefekte, wie Fehlstellen etc., wird hierbei stark von den Strömungsbedingungen der Lösung und der hiervon abhängigen Wärmeübertragung während des Abkühlens bzw. Erhitzens der Lösung beeinflußt.

Im Falle der Kristallisation aus einer ruhenden Lösung, welche z.B. durch den Einsatz von Impfkeimen unterstützt werden kann, hat sich gezeigt, daß je nach Qualität und Art der Lösung die Kristallbildung auch bei konstanter Kühlrate bzw. Heizrate stets zu einem unterschiedlichen Zeitpunkt bzw. bei einer unterschiedlichen Unterkühlung bzw. Überhitzung einsetzt. Dieser Effekt wird durch äußere Einflüsse, z.B. Erschütterungen der Lösung, noch verstärkt. Hieraus resultiert eine mangelhafte Reproduzierbarkeit, eine breite Kornverteilung der erzeugten Kristalle und somit eine unterschiedliche Kristallqualität. Hinzu kommt, daß sich in der ruhenden Lösung beim Abkühlen bzw. Erhitzen derselben ein relativ hoher Temperaturgradient ausbildet, so daß lokale Unterkühlungen bzw. Überhitzungen auftreten, was zu einer lokal unterschiedlichen Kristallbildung bzw. zu einem lokal unterschiedlichen Kristallwachstum führt. Hieraus resultiert wiederum eine breite Partikelgrößenverteilung der erzeugten Kristalle.

Eine zufriedenstellende Reproduzierbarkeit liefert einzig der Einsatz von Impfkeimen bei einer fest vorgegebenen Übersättigungstemperatur. Nachteilig ist jedoch, daß auf diese Weise einerseits die Herstellung sehr feiner Partikel nicht möglich ist, andererseits ist insbesondere bei pharmazeutischen Wirkstoffen oder Treib- und Explosivstoffen häufig eine größtmögliche Reinheit der Kristalle erwünscht, so daß der Einsatz von Impfkeimen ausscheidet und gleichmäßig treibende Potentiale zur Keimbildung erforderlich sind. Bei Kristallen aus Treib- und Explosivstoffen kommt hinzu, daß die Reduzierung von Fehlstellen mit einer erheblichen Verminderung ihrer Empfindlichkeit einhergeht, was in handhabungstechnischer und insbesondere in sicherheitstechnischer Hinsicht von Bedeutung ist.

Im Falle einer Agitation der Lösung während des Abkühlens bzw. Erhitzens, was vornehmlich durch den Einsatz von rührkesselartigen Kristallisatoren geschieht, wird aufgrund der zumindest lokal turbulenten Strömungsverhältnisse zwar ein einwandfreier innerer Wärmeübergang sichergestellt und die Ausbildung eines Temperaturgradienten in der Lösung weitestgehend vermieden. Gleichwohl treten hinsichtlich einer gezielten Kristallbildung und eines homogenen Kristallwachstums erhebliche Schwierigkeiten auf. So kommt es aufgrund der lokal sehr unterschiedlichen Strömungsbedingungen einerseits zu einer in der Literatur als "crystal growth dispersion" beschriebenen breiten Partikelgrößenverteilung, andererseits weisen die derart erzeugten Partikel teils erhebliche Kristalldefekte, insbesondere Fehlstellen auf. Ferner sind der Partikelgröße sowohl bei der Kristallisation aus ruhender Lösung als auch bei Agitation derselben mittels Rühren oder in einer Rohrströmung nach unten hin Grenzen gesetzt und enge Partikelgrößenverteilungen nicht erzielbar.

Der Erfindung liegt die Aufgabe zugrunde, ein Verfahren und eine Vorrichtung vorzuschlagen, welche die kostengünstige Herstellung von regelmäßigen Kristallen hoher Reinheit mit definierten Eigenschaften, wie mittlerer Partikelgröße, enger Partikelgrößenverteilung, hoher Reproduzierbarkeit und insbesondere keinen oder nur geringen Kristalldefekten ermöglicht.

In verfahrenstechnischer Hinsicht wird diese Aufgabe erfindungsgemäß bei einem Verfahren der eingangs genannten Art zur Herstellung von Kristallen aus wenigstens einem in einem Lösungsmittel gelösten Feststoff mit positiver Löslichkeit dadurch gelöst, daß die Lösung in einer laminaren Scherströmung (Couette-Strömung) abgekühlt wird. Entsprechend ist bei einem Verfahren zur Herstellung von Kristallen aus wenigstens einem in einem Lösungsmittel gelösten Feststoff mit negativer Löslichkeit der eingangs genannten Art zur Lösung der Erfindungsaufgabe vorgesehen, daß die Lösung in einer laminaren Scherströmung (Couette-Strömung) erhitzt wird.

Verfahren zur Ausfällung von nicht kristallinen Feststoffen in einer Couette-Strömung sind bekannt.

Die DE 27 22 636 A1 beschreibt ein Verfahren zur Herstellung von faserförmigen Polymerpartikeln aus einer Polymerlösung, indem die in Lösung vorgelegten Polymerketten in einer Couette-Strömung unter Einsatz von Impfkeimen in paralleler Orientierung zu den Polymerfasern zusammengelagert werden. Das longitudinale Wachstum der Polymerfasern geschieht unter Berührung derselben mit einem zur Erzeugung der Couette-Strömung vorgesehenen Rotor.

Der DE 41 03 575 C2 ist ein Verfahren zur Herstellung von Butter entnehmbar, indem die Butter aus einer Fettemulsion oder -schmelze in einer Couette-Strömung unter stufenweiser Temperaturabsenkung in Abhängigkeit der unterschiedlichen Schmelzpunkte der in der Suspension vorhandenen Fettsäuren ausgefällt wird. Mit dem Verfahren soll die Streichfähigkeit des Endproduktes verbessert werden. Zur Durchführung des Verfahrens wird eine Vorrichtung gemäß dem Oberbegriff des Anspruchs 11 vorgeschlagen. Ein ähnliches Verfahren ist der DE 41 25 463 A1 zu entnehmen.

Ferner ist es bekannt, eine Suspensionspolymerisation in einer zwischen rotierenden, koaxial angeordneten Zylindern erzeugten Scherströmung durchzuführen (JP 05-132 504 A).

Die genannten Verfahren konnten der Fachwelt jedoch keinerlei Anregungen zur Lösung des der Erfindung zugrunde liegenden Problems geben, da den bekannten Verfahren eine völlig andere Wirkungsweise wie die nachfolgend erläuterte Wirkungsweise des erfindungsgemäßen Kristallisationsverfahrens zugrunde liegt.

Aufgrund der homogenen und im wesentlichen gleichartigen Strömungsverhältnisse im Strömungsfeld der laminaren Scher- bzw. Schichtenströmung (Couette-Strömung) werden über den gesamten Strömungsquerschnitt sehr ähnliche Kristallisations- bzw. Wachstumsbedingungen geschaffen, so daß unter Vermeidung des Einsatzes von Impfkeimen hochreine und weitestgehend fehlstellenfreie Kristalle mit einer engen, quasimonomodalen Partikelgrößenverteilung reproduzierbar hergestellt werden. Der hydrodynamische Transport der übersättigten Lösung an die Phasengrenze der ausfallenden Kristalle in Form einer homogenen Anströmung derselben sorgt für ein sehr homogenes Kristallwachstum unter weitestgehender Vermeidung von Kristalldefekten. Ebenfalls gewährleistet die Couette-Strömung einen hinreichenden Wärmetransport der Lösung, wobei insbesondere im Falle der Erzeugung der Couette-Strömung in einem möglichst engen Spalt zweier relativ zueinander bewegten konzentrischen Zylindern oder parallelen Platten die Ausbildung eines Temperaturgradienten in der Lösung minimiert wird. Nach Beendigung des Kristallwachstums werden die Kristalle auf herkömmliche Weise mechanisch, z.B. mittels Filter, von dem Lösungsmittel getrennt.

Mittels des erfindungsgemäßen Verfahrens ist es auch möglich, die Partikelgröße des Feststoffkristallisates durch Variation der Kühl- bzw. Heizrate und/oder durch die Strömungsgeschwindigkeit der Couette-Strömung zu steuern. Sind beispielsweise feinpartikuläre Kristalle erwünscht, so wird eine verhältnismäßig hohe Kühl- bzw. Heizrate und/oder eine verhältnismäßig niedrige Strömungsgeschwindigkeit eingestellt, so daß nach Unter- bzw. Überschreiten der Sättigungstemperatur infolge der definierten Strömungsverhältnisse über den gesamten Strömungsquerschnitt spontan eine Vielzahl von Keimen erzeugt wird. Alternativ oder zusätzlich kann die Verweilzeit der Lösung in der Couette-Strömung verhältnismäßig kurz gewählt werden. Sind hingegen größere Kristalle von Interesse, so wird die Kühl- bzw. Heizrate entsprechend niedriger und/oder die Strömungsgeschwindigkeit entsprechend höher eingestellt, so daß weniger Keime gebildet werden und ein größerer Anteil des Feststoffs in Lösung verbleibt, der während des Kristallwachstums infolge weiterer Abkühlung bzw. Beheizung der Lösung auskristallisiert und durch Anströmung der gebildeten Kristallkeime an diesen abgeschieden wird. In jedem Fall wird aufgrund der Abkühlung bzw. Erhitzung der Lösung in der Couette-Strömung ein gegenüber herkömmlichen Kühlungskristallisationsverfahren homogeneres Kristallwachstum und somit die Bildung regelmäßigerer und defektärmerer bzw. -freier Kristalle erreicht

Die Lösung kann mit einer im wesentlichen konstanten Kühl- bzw. Heizrate oder mit einer z.B. im Bereich der Sättigungstemperatur der Lösung verminderten Kühl- bzw. Heizrate abgekühlt bzw. erhitzt werden. Ebenfalls ist es möglich, daß die Temperatur der Lösung im Bereich der Sättigungstemperatur der Lösung für einige Zeit im wesentlichen konstant gehalten wird. Grundsätzlich richtet sich die Kühl- bzw. Heizrate vornehmlich nach der gewünschten Partikelgröße der Kristalle, wobei in der Regel um so regelmäßigere Kristalle erzeugt werden, je geringer die Kühlrate bzw. Heizrate gewählt wird bzw. je langsamer das Kristallwachstum erfolgt. Grundsätzlich sei an dieser Stelle nochmals erwähnt, daß die Kühlungskristallisation für Stoffsysteme mit positiver Löslichkeit und die Heizkristallisation für Systeme mit negativer Löslichkeit zum Einsatz kommt.

Das erfindungsgemäße Verfahren kann entweder chargenweise (diskontinuierlich) oder kontinuierlich bzw. semikontinuierlich durchgeführt werden. Hierbei sieht eine Ausführungsvariante vor, daß die Couette-Strömung zur kontinuierlichen oder semikontinuierlichen Durchführung des Verfahrens mit einer hierzu senkrechten laminaren Strömung der Lösung überlagert wird. Die laminare Strömung der z.B. übersättigten Lösung wird also kontinuierlich durch das hierzu senkrechte Couette-Strömungsfeld durchgeleitet und die dort infolge des Abkühlens bzw. Erhitzens gebildeten Kristalle kontinuierlich oder semikontinuierlich entnommen. Insbesondere ist auf diese Weise ein Kreislaufbetrieb möglich, indem das Lösungsmittel nach Abtrennen der Partikel mit dem zu kristallisierenden Feststoff beaufschlagt und rezirkuliert wird.

Wie bereits angedeutet, ist das erfindungsgemäße Verfahren insbesondere zur Herstellung von Kristallen aus thermisch empfindlichen Feststoffen, wie Treib-, Explosivstoffen und Oxidatoren, Pharmazeutika und pharmazeutischen Wirkstoffen, Hormonen und Hormonderivaten oder homöopathischen Wirkstoffen bzw. Konzentraten pflanzlicher Wirkstoffe, geeignet, wobei fehlstellenarme und regelmäßige Kristalle mit definierter Partikelgröße, enger Partikelgrößenverteilung und hoher Schüttdichte reproduzierbar erhalten werden können.

Ein besonders bevorzugtes Anwendungsgebiet von mittels des erfindungsgemäßen Verfahrens hergestellten, im wesentlichen fehlstellenfreien Kristallen aus Treib-, Explosivstoffen und/oder Oxidaten liegt im Einsatz derselben in polymergebundenen Treib- und Sprengsätzen, beispielsweise für Raketenfesttreibstoffe. Hierbei werden die auf vorgenannte Weise erzeugten Kristalle in eine Polymermatrix, z.B. aus HTPB (Hydroxy-terminated Polybutadien), GAP (Glycidylazidopolymeren) oder dergleichen, eingearbeitet, wobei sich aufgrund der nur äußerst geringen Kristalldefekte eine Reduzierung der Empfindlichkeit solcher Explosivstoffsysteme um etwa 50% gegenüber polymergebundenen Treib- und Sprengsätzen mit auf herkömmliche Weise hergestellten Explosivstoffpartikel ergibt.

Als Treib-, Explosivstoffe bzw. Oxidatoren kommen im Prinzip beliebige bekannte Vertreter derselben, wie 2,4,6-Trinitrotoluol (TNT), 1,3,5-Triamino-2,4,6-trinitrobenzol (TATNB), 3-Nitro-1,2,4-triazol-5-on (NTO), Hexanitrostilben (HNS), Cyclotrimethylentrinitramin (Hexogen, RDX), Cyclotetramethylentetranitramin (Oktogen, HMX), Ammoniumdinitramid (ADN), 2,4,6,8,10,12-Hexanitro-2,4,6,8,10,12-hexaazaisowurtzitan (HNIW, auch als CL20 bezeichnet), Pentaerythritoltetranitrat (Nitropenta, PETN), Hexanitrodiphenylamin (Hexyl), Tetranitromethylanilin (Tetryl), Nitroguanidin (NQ), Triaminoguanidinnitrat (TAGN), Ammoniumnitrat (AN), etc.

Die Erfindung betrifft auch eine Vorrichtung zur Herstellung von Kristallen aus wenigstens einem in einem Lösungsmittel gelösten Feststoff, insbesondere zur Durchführung des Verfahrens der vorgenannten Art, mit wenigstens einem im wesentlichen zylindrischen Kristallisationsbehälter zur Aufnahme der Lösung mit einem hierzu koaxial unter Bildung eines radialen Ringraums angeordneten und relativ zu diesem rotierbaren, im wesentlichen zylindrischen Innenteil, wobei der Kristallisationsbehälter und/oder das Innenteil temperierbar ist/sind. Die erfindungsgemäße Vorrichtung ist dadurch gekennzeichnet, daß dem Kristallisationsbehälter in Richtung seiner Mittelsenkrechten ein mit diesem in Verbindung stehender Speisebehälter mit einem dem Querschnitt des Kristallisationsbehälters etwa entsprechenden Querschnitt mit einem Zulauf für die Lösung vorgeordnet ist, welcher über einen fluidpermeablen Einsatz, wie eine Membran, eine Fritte, ein Filter oder dergleichen, mit dem Kristallisationsbehälter in Verbindung steht und zum Beaufschlagen des Kristallisationsbehälters mit einer in Richtung seiner Mittelsenkrechten gerichteten Laminarströmung dient.

Die erfindungsgemäße Ausgestaltung gewährleistet eine gleichförmige laminare Anströmung des Kristallisationsbehälters, wobei der Speisebehälter bevorzugt einen hinreichend langen Einlaufweg zur Ausbildung einer an der Mündung zum Kristallisationsbehälter laminaren Strömung der dem Speisebehälter über den Zulauf zugeführten Lösung bildet. Durch relative Rotation des Innenteils bezüglich des Kristallisationsbehälters wird in dem zwischen diesen gebildeten Ringraum die zur Kristallisation des Feststoffes dienende Couette-Strömung erzeugt. Insbesondere können sowohl das Innenteil als auch der Kristallisationsbehälter temperierbar sein, um die Ausbildung eines Temperaturgradienten im Strömungsprofil der Couette-Strömung weitestgehend zu vermeiden. Die erfindungsgemäße Vorrichtung arbeitet kontinuierlich oder semikontinuierlich, wobei die in dem Ringraum zwischen dem Innenteil und dem Kristallisationsbehälter erzeugte Couette-Strömung mit einer hierzu senkrecht gerichteten Laminarströmung überlagert werden kann, so daß dem Kristallisationsbehälter über den Speisebehälter kontinuierlich frische, insbesondere übersättigte Lösung zugeführt werden kann.

Mit "im wesentlichen zylindrisch" ist in diesem Zusammenhang einerseits eine zylindrische, insbesondere kreiszylindrische, Ausgestaltung von Kristallisationsbehälter und/oder Innenteil gemeint, andererseits können diese beispielsweise auch als an eine zylindrische Form angenähertes gerades Vieleckprisma ausgebildet sein, um je nach Viskosität der Lösung eine erhöhte Wandreibung an den relativ zueinander bewegten Teilen zu erzielen.

Aus konstruktionstechnischen Gründen ist/sind mit Vorzug der Kristallisationsbehälter und/oder das Innenteil kreiszylindrisch ausgebildet. Ferner ist vorzugsweise der Kristallisationsbehälter stationär und das Innenteil rotierbar.

Um eine gleichmäßige Couette-Strömung in dem zwischen dem Innenteil und dem Kristallisationsbehälter gebildeten Ringraum zu erzielen, konvergiert das Innenteil mit Vorzug an einem unteren Abschnitt in Richtung des Mittelpunktes des Bodens des Kristallisationsbehälters. Alternativ kann das Innenteil auch den Boden des Kristallisationsbehälters durchsetzen.

Der Kristallisationsbehälter ist zweckmäßig an seiner dem Speisebehälter abgewandten Seite mit einem weiteren fluidpermeablen Einsatz, wie einer Membran, einer Fritte, einem Filter oder dergleichen, ausgestattet, an welchen sich ein Abführbehälter mit einem Ablauf zum Abführen des Lösungsmittels anschließt. An diesem Einsatz werden die in dem temperierbaren Kristallisationsbehälter erzeugten Kristalle abgeschieden und können beispielsweise semikontinuierlich entnommen werden. Insbesondere ist es auch möglich, daß dem an der dem Speisebehälter abgewandten Seite des Kristallisationsbehälters angeordneten Einsatz eine Fördereinrichtung zum kontinuierlichen Abführen der erzeugten Kristalle zugeordnet ist.

Je nach Viskosität der Lösung bzw. je nach der gewünschten Reibung der Lösung an der Innenseite des Kristallisationsbehälters und/oder an der Mantelfläche des Innenteils können diese profiliert ausgebildet oder mit einer Oberflächenrauhigkeit versehen oder auch glatt ausgebildet, insbesondere poliert sein. Alternativ oder zusätzlich kann/können der Kristallisationsbehälter und/oder das Innenteil, wie bereits erwähnt, einen vieleckigen Querschnitt aufweisen.

Der Kristallisationsbehälter und/oder das Innenteil kann/können aus Metall oder Metallegierungen, Keramik, Glas oder Kunststoff bestehen. Im Rahmen von Experimenten wurde festgestellt, daß gewisse Materialien, wie Polytetrafluorethylen (PTFE), Polyethylen (PE) und einige Polyurethane, bei bestimmten aus Lösungsmittel und gelöstem Feststoff bestehenden Systemen die Kristallbildung fördern. Im Falle des Einsatzes solcher Stoffsysteme kann/können der Kristallisationsbehälter und/oder das Innenteil vorzugsweise mit solchen Kunststoffen beschichtet sein oder auch gänzlich hieraus bestehen.

Nachstehend ist die Erfindung anhand von Ausführungsbeispielen unter Bezugnahme auf die Zeichnungen näher erläutert. Es zeigen:
- Fig. 1: das Strömungsprofil einer laminaren Scherströmung (Couette-Strömung) einer Kristallisationslösung mit linearem (Newtonschem) Fließverhalten;
- Fig. 2: das Strömungsprofil einer Couette-Strömung einer Kristallisationslösung mit nicht linearem Fließverhalten;
- Fig. 3: eine schematische Schnittansicht einer diskontinuierlich arbeitenden Vorrichtung zur Herstellung von Kristallen;
- Fig. 4: eine Ausführungsvariante der Vorrichtung gemäß Fig. 3 und
- Fig. 5: eine Ausführungsform einer erfindungsgemäßen, semikontinuierlich arbeitenden Vorrichtung zur Herstellung von Kristallen.

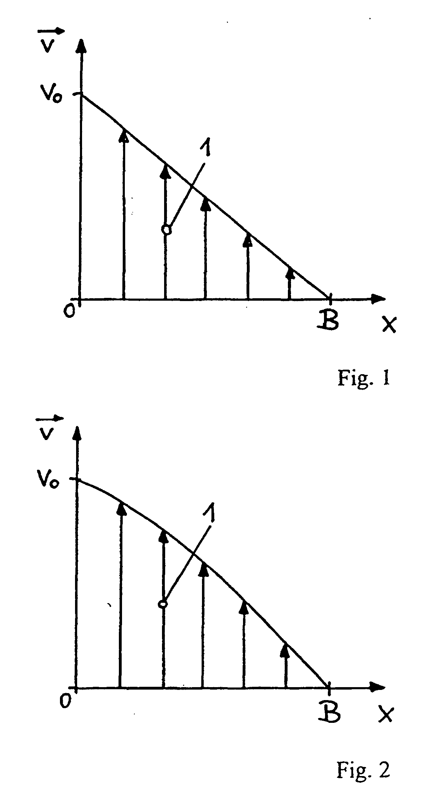

Fig. 1 zeigt das Strömungsprofil einer Couette-Strömung einer Kristallisationslösung, wie sie beispielsweise in einem Ringraum der Breite B zwischen zwei konzentrischen Zylindern (nicht dargestellt) auftritt, wenn einer der Zylinder bezüglich dem anderen mit der Umlaufgeschwindigkeit v₀ rotiert wird. Wie aus Fig.1 ersichtlich, geschieht der hydrodynamische Transport der Lösung an die Phasengrenze von im Strömungsfeld ausfallenden Kristallen 1 in Form einer gleichmäßigen und homogenen Anströmung derselben, welche für ein homogenes Kristallwachstum unter weitestgehender Vermeidung von Kristalldefekten sorgt.

Das in Fig. 2 dargestellte Strömungsprofil einer Couette-Strömung unterscheidet sich von dem Strömungsprofil gemäß Fig. 1 dadurch, daß es anstelle eines linearen Geschwindigkeitsprofils ein mehr oder minder ellipsenförmiges Geschwindigkeitsprofil aufweist, wie es sich bei nicht linearem Fließverhalten der Lösung, beispielsweise nach zunehmender Kristallbildung, einstellt. Auch hier werden über den gesamten Strömungsquerschnitt sehr gleichförmige Kristallisations- bzw. Wachstumsbedingungen für die gebildeten Kristalle 1 geschaffen, so daß hochreine und weitestgehend fehlstellenfreie Kristalle mit einer engen, quasimonomodalen Partikelgrößenverteilung reproduzierbar hergestellt werden können.

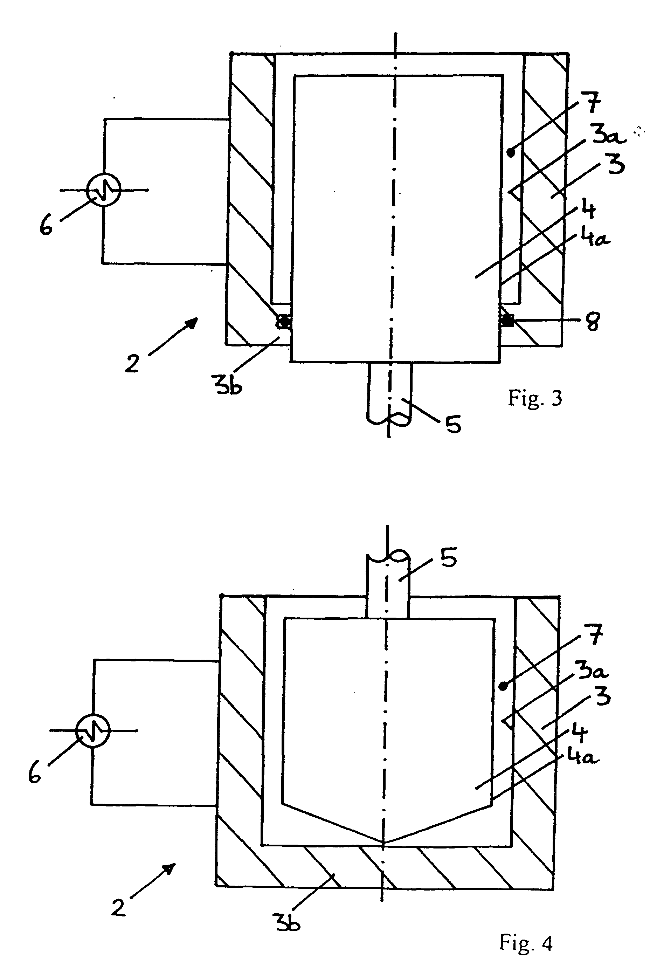

Fig. 3 zeigt eine diskontinuierlich arbeitende Vorrichtung 2 zur Herstellung von Kristallen aus in Lösungsmitteln gelösten Feststoffen. Sie umfaßt einen kreiszylindrischen Kristallisationsbehälter 3 zur Aufnahme der Lösung mit einem hierzu koaxial innerhalb desselben angeordneten und relativ zu diesem rotierbaren Innenteil 4 in Form eines Kreiszylinders. Zwischen dem Kristallisationsbehälter 3 und dem kreiszylindrischen Innenteil 4 ist ein radialer Ringraum 7 gebildet. Beim vorliegenden Ausführungsbeispiel ist der Kristallisationsbehälter 3 stationär und der Kreiszylinder 4 über eine mit einem Antriebsmotor (nicht gezeigt) verbundene Welle 5 rotierbar. Der Kristallisationsbehälter 3 ist mittels einer Kühl-/Heizeinrichtung 6 temperierbar. Alternativ oder zusätzlich kann auch der Kreiszylinder 4 temperierbar sein, um die Ausbildung eines Temperaturgradienten in der im Ringraum 7 zwischen dem Kristallisationsbehälter 3 und dem Kreiszylinder 4 vorhandenen Kristallisationslösung weitestgehend zu vermeiden. Je nach der gewünschten Wandreibung der Lösung kann die Innenseite 3a des Kristallisationsbehälters 3 und/oder die Mantelfläche 4a des Kreiszylinders 4 profiliert bzw. mit einer Oberflächenrauhigkeit versehen oder auch glatt ausgebildet, insbesondere poliert sein.

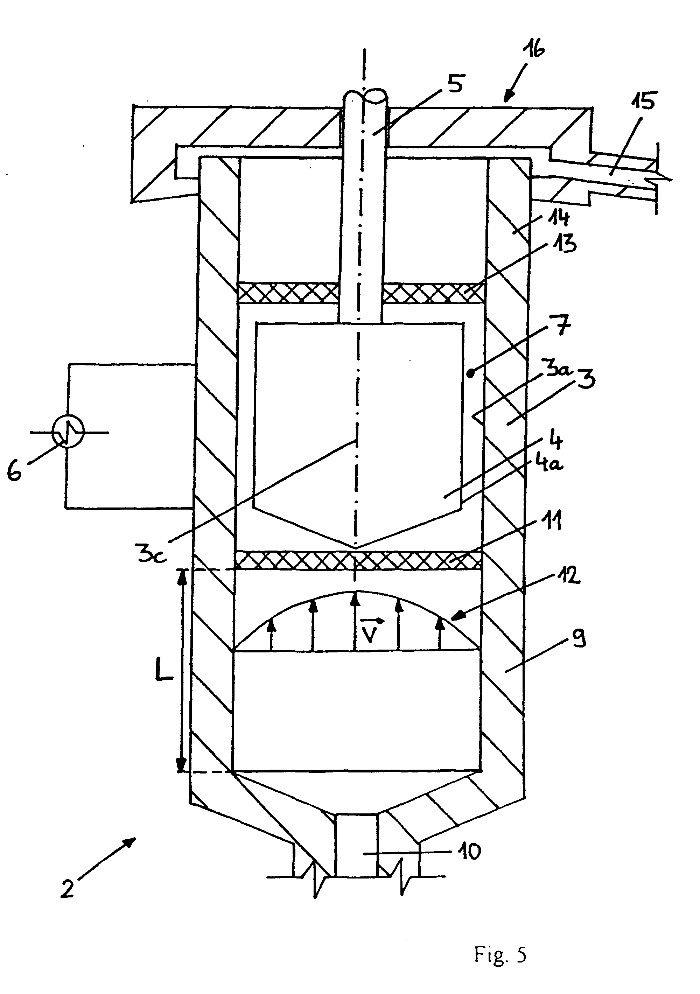

Während der Kreiszylinder 4 bei der Ausführungsform gemäß Fig. 3 den Kristallisationsbehälter 3 bodenseitig durchsetzt und mittels einer Dichtung 8, wie einer Gleitringdichtung oder dergleichen, gegen den Behälter 3 abgedichtet ist, konvergiert der Kreiszylinder 4 bei der in Fig.4 dargestellten Ausführungsform in Richtung des Mittelpunktes des Bodens 3d des Kristallisationsbehälters 3. In beiden Fällen wird beim Rotieren des Zylinders 4 bezüglich des Kristallisationsbehälters 3 im Ringraum 7 eine Couette-Strömung erzeugt, wie sie in Abhängigkeit der Viskosität der Lösung in Fig. 1 bzw. Fig. 2 dargestellt ist.

Zur Herstellung von Kristallen aus einem in einem Lösungsmittel gelösten Feststoff wird die Lösung in den Kristallisationsbehälter 3 überführt und das zylindrische Innenteil 4 z.B. mit konstanter Umlaufgeschwindigkeit v₀ (Fig. 1 und 2) rotiert, so daß in dem Ringraum 7 eine Couette-Strömung erzeugt wird. Sodann wird der Behälter 3 je nach Löslichkeitsverhalten des aus Lösungsmittel und gelöstem Feststoff gebildeten Systems abgekühlt (System mit positiver Löslichkeit) oder erhitzt (System mit negativer Löslichkeit). Anschließend werden die erzeugten Kristalle mittels Filtern oder dergleichen vom Lösungsmittel abgetrennt, gewaschen und getrocknet.

Der Fig.5 ist eine erfindungsgemäße, semikontinuierlich arbeitende Vorrichtung 2 zur Herstellung von Kristallen aus in Lösungsmitteln gelösten Feststoffen entnehmbar. Entsprechend den in Fig. 4 und 5 dargestellten diskontinuierlich arbeitenden Vorrichtungen ist ein kreiszylindrischer Kristallisationsbehälter 3 mit einem koaxial innerhalb desselben angeordneten Innenteil 4 in Form eines Kreiszylinders 4 vorgesehen, welche einen radialen Ringraum 7 begrenzen. Das kreiszylindrische Innenteil ist über eine z.B. mit einem Elektromotor (nicht gezeigt) verbundene Welle 5 rotierbar ist. Der Kristallisationsbehälter 3 ist über eine Heiz/Kühleinrichtung 6 temperierbar.

Dem Kristallisationsbehälter 3 ist in Richtung seiner Mittelsenkrechten 3c ein Speisebehälter 9 mit einem Zulauf 10 für die Kristallisationslösung vorgeordnet, welcher beim vorliegenden Ausführungsbeispiel unterhalb des Kristallisationsbehälters 3 angeordnet ist. Der Speisebehälter 9 steht über einen seinen Boden bildenden fluidpermeablen Einsatz 11 in Form einer Membran, einer Fritte oder eines Filters mit dem Kristallisationsbehälter 3 in Verbindung, wobei der Querschnitt des Kristallisationsbehälters 3 dem Querschnitt des Speisebehälters 9 entspricht.

Der Speisebehälter 9 dient zum Beaufschlagen des Kristallisationsbehälters 3 mit einer in Richtung seiner Mittelsenkrechten 3c und bezüglich der bei rotierendem Kreiszylinder 4 in dem Ringraum 7 zwischen letzterem und dem Kristallisationsbehälter 3 erzeugten Couette-Strömung senkrecht gerichteten laminaren Steigströmung 12 der Kristallisationslösung. Der zwischen dem unterseitigen Einlauf 10 des Speisebehälters 9 und dem Einsatz 11 verlaufende Strömungsweg L der zugeführten Lösung ist so bemessen, daß sich beim Eintritt der Lösung in den Kristallisationsbehälter 3 ein laminares Geschwindigkeitsprofil 12 eingestellt, welches von den durch die Querschnittserweiterung des Einlaufs 10 erzeugten Verwirbelungen weitestgehend frei ist, um in dem Kristallisationsbehälter 3 für ein homogenes Strömungsprofil zu sorgen, indem die Couette-Strömung mit der laminaren Strömung 12 überlagert wird. Zweckmäßig konvergiert das kreiszylindrische Innenteil 4 des Kristallisationsbehälters 3 an seinem unteren Abschnitt in Richtung des Mittelpunktes des Einsatzes 11, um die laminare Strömung 12 gleichmäßig in den Ringraum 7 zu leiten und Staupunkte bzw. hierdurch verursachte Rückströmungen bestmöglich zu verhindern.

An seiner dem Speisebehälter 9 abgewandten Oberseite des Kristallisationsbehälters 3 ist ein weiterer fluidpermeabler Einsatz 13 vorgesehen, welcher ebenfalls von einer Membran, einer Fritte, einem Filter oder dergleichen gebildet sein kann und von der Antriebswelle 5 des Zylinders 4 durchsetzt ist. Der Einsatz 13 dient zum Zurückhalten der im Kristallisationsbehälter 3 erzeugten fehlstellenfreien Kristalle, die sich an dessen dem Kristallisationsbehälter 3 zugewandten Unterseite anreichern und beispielsweise semikontinuierlich entnommen werden können. An den Einsatz 13 schließt sich ein Abführbehälter 14 mit einem Ablauf 15 zum Abführen des Lösungsmittels an, welcher beim vorliegenden Ausführungsbeispiel in Form eines in einen Deckel 16 integrierten Überlaufs gebildet ist. Zum Rezirkulieren des über den Ablauf 15 abgeführten Lösungsmittels kann ferner eine mit dem Zulauf 10 des Speisebehälters 9 korrespondierende Rückführleitung vorgesehen sein, welche mit dem jeweiligen zu kristallisierenden Feststoff beaufschlagbar ist (nicht dargestellt).

Um eine kontinuierliche Betriebsweise der Vorrichtung zu gewährleisten, kann an der dem Kristallisationsbehälter 3 zugewandten Unterseite des Einsatzes 13 eine Fördereinrichtung zum kontinuierlichen Abführen der erzeugten Kristalle vorgesehen sein, die z.B. in Form von an der Welle 5 festgelegten und mit dieser umlaufenden Schaufeln gebildet sein kann, welche die abgeschiedenen Kristalle einer unterhalb des Einsatzes 13 angeordneten, den Kristallisationsbehälter 3 radial durchsetzenden Abführleitung zuführt (nicht dargestellt).

Die Betriebsweise der Vorrichtung 2 gemäß Fig. 5 ist weiter unten in Verbindung mit dem Ausführungsbeispiel 2 im einzelnen erläutert.

Nachstehend ist die Erfindung anhand von Ausführungsbeispielen näher erläutert:

### Beispiel 1

Zur chargenweisen Herstellung von Kristallen aus Cyclotetramethylentetranitramin (Oktogen, HMX) werden 150 g HMX und 900 g Propylencarbonat bei Raumtemperatur vermischt. Die Mischung wird in einen Kristallisator 2 aus Edelstahl (V4A-Stahl) gemäß Fig. 4 überführt und der koaxial in dessen Kristallisationsbehälter angeordnete Zylinder in Rotation versetzt, so daß sich in dem Ringraum zwischen letztgenannten eine Couette-Strömung ergibt. Die Mischung wird auf 95°C erhitzt, um die gesamte Menge an HMX in dem Propylencarbonat zu lösen. Das aus dem Lösungsmittel Propylencarbonat und dem zu kristallisierenden Feststoff HMX bestehende System befindet sich somit im Bereich der Sättigung. Anschließend wird die Lösung auf 75°C abgekühlt und sodann 50 ml Wasser zugegeben, um die Keimbildung zu initiieren.

Anschließend wird die Kristallisationslösung mit einer konstanten Kühlrate von 15°C/min in der Couette-Strömung auf 5°C abgekühlt. Das entstehende Feststoffkristallisat wird mittels eines Filters von dem Lösungsmittel getrennt und mit Dimethylketon (Aceton) gewaschen und getrocknet.

Die auf diese Weise hergestellten HMX-Kristalle weisen einen mittleren Partikeldurchmesser von 350 µm und eine enge Partikelgrößenverteilung auf. Die Dichte der erhaltenen Kristalle konnte gegenüber auf herkömmliche Weise (Kühlungskristallisation in einem Rührkessel unter ansonsten identischen Bedingungen) erzeugten Kristallen von 1,888 g/cm³ auf 1,912 g/cm³ erhöht werden, was auf eine äußerst geringe Anzahl von Kristalldefekten bzw. Fehlstellen schließen läßt.

Zur Bestimmung der Empfindlichkeit wurden sowohl die auf vorstehende Weise in einer Couette-Strömung hergestellten HMX-Kristalle als auch die herkömmlich in einer zumindest bereichsweise laminaren Rührkesselströmung erzeugten HMX-Kristalle einem sogenannten "Gap-Test" unterzogen. Bei diesem Test wird zur Untersuchung der HMX-Kristalle ein polymergebundener Treibsatz (PBX) hergestellt. Hierzu werden die HMX-Partikel in einem Verhältnis von 70 Mass.-% in einen Polymerbinder aus HTPB (Hydroxy-terminated Polybutadien) eindispergiert. Auf diesen Treibsatz wird in senkrechter Richtung eine Plexiglasplatte aufgelegt und an der dem Treibsatz abgewandten Seite der Plexiglasplatte eine standardisierte Geberladung gezündet. Die Plexiglasplatte dient als Übertragungsmedium auf den zu untersuchenden PBX-Treibsatz durch Zünden der Geberladung. Durch Variation der Dicke der Plexiglasplatte erhält man den zur Dicke proportionalen Stoßwellendruck, der nach Durchlaufen der Plexiglasplatte gerade noch Detonation auslöst. Während die auch mit "Gap-Höhe" bezeichnete Dicke der Plexiglasplatte, bei der gerade noch Detonation des zu untersuchenden PBX-Treibsatz ausgelöst werden konnte, bei den PBX mit den herkömmlich hergestellten HMX-Partikeln 13 mm betrug, betrug die Gap-Höhe bei den in der Couette-Strömung hergestellten Partikeln 7 mm, was einer Verminderung der Empfindlichkeit um 54% entspricht. Der Grund hierfür liegt in einer weitestgehenden homogenen und fehlstellenfreien Kristallstruktur.

### Beispiel 2

Zur semikontinuierlichen Herstellung von Kristallen aus HMX werden 160 g HMX bei Raumtemperatur in ein Lösungsmittelgemisch aus gleichen Anteilen von γ-Butyrolaceton und Aceton eindispergiert. Die Dispersion wird dem Zulauf des Speisebehälters eines Kristallisators gemäß Fig. 5 zugeführt, wobei die in dem Ringraum zwischen dem Kristallisationsbehälter und dem rotierenden Zylinder des Kristallisators erzeugte Couette-Strömung mit einer hierzu senkrechten laminaren Strömung überlagert wird. Unter Rezirkulation der Dispersion wird diese auf 95°C erhitzt, so daß eine gesättigte HMX-Lösung erhalten wird. Sodann wird die Lösung auf 70°C abgekühlt und 60 ml Wasser zudosiert, um die Keimbildung zu initiieren. Schließlich wird die den Kristallisationsbehälter durchströmende Lösung mit einer konstanten Kühlrate von 15°C/min. abgekühlt. Die an der dem Kristallisationsbehälter zugewandten Unterseite des oberen Einsatzes des Kristallisators angereicherten Kristalle werden von dem Lösungsmittelgemisch abgetrennt, mit Heptan gewaschen und getrocknet.

Die auf diese Weise hergestellten HMX-Kristalle weisen ebenfalls einen mittleren Partikeldurchmesser von 350 µm und eine enge Partikelgrößenverteilung auf. Die Dichte beträgt 1,908 g/cm³ und liegt somit im Bereich der im diskontinuierlichen Betrieb hergestellten Kristalle (Beispiel 1).

## Patentansprüche

1. Verfahren zur Herstellung von regelmäßigen kristallinen Feststoffpartikeln (1) mit keinen oder nur geringen Kristalldefekten, wie Fehlstellen oder dergleichen, aus wenigstens einem in einem Lösungsmittel gelösten Feststoff mit positiver Löslichkeit, indem die Lösung unter Bildung des Feststoffkristallisates bis unterhalb ihrer Sättigungstemperatur abgekühlt und das Feststoffkristallisat abgetrennt wird, **dadurch gekennzeichnet, daß** die Lösung in einer als Couette-Strömung bezeichneten laminaren Scherströmung abgekühlt wird.

2. Verfahren zur Herstellung von regelmäßigen kristallinen Feststoffpartikeln (1) mit keinen oder nur geringen Kristalldefekten, wie Fehlstellen oder dergleichen, (1) aus wenigstens einem in einem Lösungsmittel gelösten Feststoff mit negativer Löslichkeit, indem die Lösung unter Bildung des Feststoffkristallisates bis oberhalb ihrer Sättigungstemperatur erhitzt und das Feststoffkristallisat abgetrennt wird, **dadurch gekennzeichnet, daß** die Lösung in einer als Couette-Strömung bezeichneten laminaren Scherströmung erhitzt wird.

3. Verfahren nach Anspruch 1 oder 2, **dadurch gekennzeichnet**, **daß** die Partikelgröße des Feststoffkristallisates durch Variation der Kühl- bzw. Heizrate und/oder durch die Strömungsgeschwindigkeit der Couette-Strömung gesteuert wird.

4. Verfahren nach einem der Ansprüche 1 bis 3, **dadurch gekennzeichnet**, **daß** die Lösung mit einer im wesentlichen konstanten Kühlrate abgekühlt bzw. mit einer im wesentlichen konstanten Heizrate erhitzt wird.

5. Verfahren nach einem der Ansprüche 1 bis 4, **dadurch gekennzeichnet**, **daß** es chargenweise durchgeführt wird.

6. Verfahren nach einem der Ansprüche 1 bis 4, **dadurch gekennzeichnet, daß** die Couette-Strömung zur kontinuierlichen oder semikontinuierlichen Durchführung des Verfahrens mit einer hierzu senkrechten laminaren Strömung der Lösung überlagert wird.

7. Verfahren nach einem der Ansprüche 1 bis 6 zur Herstellung von im wesentlichen fehlstellenfreien Kristallen aus thermisch empfindlichen Feststoffen.

8. Verfahren nach Anspruch 7 zur Herstellung von Treib-, Explosivstoffen und/oder Oxidatoren in feinkristalliner Form.

9. Verfahren nach Anspruch 7 zur Herstellung von pharmazeutischen und/oder homöopathischen Wirkstoffen in feinkristalliner Form.

10. Verfahren nach Anspruch 7 zur Herstellung von Hormonen und/oder Hormonderivaten in feinkristalliner Form.

11. Vorrichtung (2) zur Herstellung von Kristallen (1) aus wenigstens einem in einem Lösungsmittel gelösten Feststoff, insbesondere zur Durchführung des Verfahrens nach einem der Ansprüche 1 bis 10, mit einem im wesentlichen zylindrischen Kristallisationsbehälter (3) zur Aufnahme der Lösung mit einem hierzu koaxial unter Bildung eines radialen Ringraums (7) angeordneten und relativ zu diesem rotierbaren, im wesentlichen zylindrischen Innenteil (4), wobei der Kristallisationsbehälter (3) und/oder das Innenteil (4) temperierbar ist/sind, **dadurch gekennzeichnet**, **daß** dem Kristallisationsbehälter (3) in Richtung seiner Mittelsenkrechten (3c) ein mit diesem in Verbindung stehender Speisebehälter (9) mit einem dem Querschnitt des Kristallisationsbehälters (3) etwa entsprechenden Querschnitt mit einem Zulauf (10) für die Lösung vorgeordnet ist, welcher über einen fluidpermeablen Einsatz (11), wie eine Membran, eine Fritte, ein Filter oder dergleichen, mit dem Kristallisationsbehälter (3) in Verbindung steht und zum Beaufschlagen des Kristallisationsbehälters (3) mit einer in Richtung seiner Mittelsenkrechten (3c) gerichteten Laminarströmung (12) dient.

12. Vorrichtung nach Anspruch 11, **dadurch gekennzeichnet**, **daß** der Kristallisationsbehälters (3) und/oder das Innenteil (4) kreiszylindrisch ausgebildet ist/sind.

13. Vorrichtung nach Anspruch 11 oder 12, **dadurch gekennzeichnet, daß** der Kristallisationsbehälter (3) stationär und das Innenteil (4) rotierbar ist.

14. Vorrichtung nach einem der Ansprüche 11 bis 13, **dadurch gekennzeichnet**, **daß** das Innenteil (4) an einem unteren Abschnitt in Richtung des Mittelpunktes des Bodens (3b) des Kristallisationsbehälters (3) konvergiert.

15. Vorrichtung nach einem der Ansprüche 11 bis 14, **dadurch gekennzeichnet, daß** der Kristallisationsbehälter (3) an seiner dem Speisebehälter (9) abgewandten Seite mit einem fluidpermeablen Einsatz (13), wie einer Membran, einer Fritte, einem Filter oder dergleichen, ausgestattet ist, an welchen sich ein Abführbehälter (14) mit einem Ablauf (15) zum Abführen des Lösungsmittels anschließt.

16. Vorrichtung nach Anspruch 15, **dadurch gekennzeichnet**, **daß** dem an der dem Speisebehälter (9) abgewandten Seite des Kristallisationsbehälters (3) angeordneten Einsatz (13) eine Fördereinrichtung zum kontinuierlichen Abführen der erzeugten Kristalle zugeordnet ist.

17. Vorrichtung nach einem der Ansprüche 11 bis 16, **dadurch gekennzeichnet**, **daß** die Innenseite des Kristallisationsbehälters (3) und/oder die Mantelfläche des Innenteils (4) profiliert oder mit einer Oberflächenrauhigkeit versehen sind.

18. Vorrichtung nach einem der Ansprüche 11 bis 16, **dadurch gekennzeichnet**, **daß** die Innenseite des Kristallisationsbehälters (3) und/oder die Mantelfläche des Innenteils (4) glatt ausgebildet, insbesondere poliert sind.

19. Vorrichtung nach einem der Ansprüche 11 bis 18, **dadurch gekennzeichnet**, **daß** der Kristallisationsbehälter (3) und/oder das Innenteil (4) aus Metall oder Metallegierungen besteht/bestehen.

20. Vorrichtung nach einem der Ansprüche 11 bis 18, **dadurch gekennzeichnet**, **daß** der Kristallisationsbehälter (3) und/oder das Innenteil (4) aus Keramik besteht/bestehen.

21. Vorrichtung nach einem der Ansprüche 11 bis 18, **dadurch gekennzeichnet**, **daß** der Kristallisationsbehälter (3) und/oder das Innenteil (4) aus Glas besteht/bestehen.

22. Vorrichtung nach einem der Ansprüche 11 bis 18, **dadurch gekennzeichnet, daß** der Kristallisationsbehälter (3) und/oder das Innenteil (4) aus Kunststoff besteht/bestehen.

23. Vorrichtung nach einem der Ansprüche 11 bis 22, **dadurch gekennzeichnet**, **daß** der Kristallisationsbehälter (3) und/oder das Innenteil (4) mit Kunststoff beschichtet ist/sind.

## Claims

1. Process for the production of regular crystalline solid particles (1) with no or only slight crystal defects such as flaws or similar, from at least one solid with positive solubility dissolved in a solvent, by cooling the solution to below its saturation temperature to form the solid crystallisate and separating the solid crystallisate, **characterised in that** the solution is cooled in a laminar shear flow referred to as a Couette flow.

2. Process for the production of regular crystalline solid particles (1) with no or only slight crystal defects such as flaws or similar, (1) from at least one solid with negative solubility dissolved in a solvent, by heating the solution to above its saturation temperature to form the solid crystallisate and separating the solid crystallisate, **characterised in that** the solution is heated in a laminar shear flow referred to as a Couette flow.

3. Process according to Claim 1 or 2, **characterised in that** the particle size of the solid crystallisate is controlled by variation of the cooling or heating rate and/or by the flow rate of the Couette flow.

4. Process according to one of Claims 1 to 3, **characterised in that** the solution is cooled at an essentially constant cooling rate or is heated at an essentially constant heating rate.

5. Process according to one of Claims 1 to 4, **characterised in that** it is performed in batches.

6. Process according to one of Claims 1 to 4, **characterised in that** for continuous or semi-continuous performance of the process, the Couette flow is superposed with a laminar flow of the solution perpendicular thereto.

7. Process according to one of Claims 1 to 6 for the production of essentially flaw-free crystals from thermally sensitive solids.

8. Process according to Claim 7 for the production of propellants, explosives and/or oxidisers in finely crystalline form.

9. Process according to Claim 7 for the production of pharmaceutical and/or homeopathic active substances in finely crystalline form.

10. Process according to Claim 7 for the production of hormones and/or hormone derivatives in finely crystalline form.

11. Apparatus (2) for the production of crystals (1) from at least one solid dissolved in a solvent, in particular for conducting the process according to one of Claims 1 to 10, with an essentially cylindrical crystallisation tank (3) to receive the solution with an essentially cylindrical inside part (4), which is arranged coaxially thereto to form a radial annular space (7) and is rotatable relative to this, wherein the crystallisation tank (3) and/or the inside part (4) can be temperature-controlled, **characterised in that** upstream of the crystallisation tank (3) in the direction of its mean perpendicular (3c) is a feed tank (9) connecting to this with a cross-section approximately corresponding to the cross-section of the crystallisation tank (3) with a feed pipe (10) for the solution, which via a fluid-permeable insert (11) such as a membrane, a diffuser, a filter or similar, connects to the crystallisation tank (3) and serves to charge the crystallisation tank (3) with a laminar flow (12) directed in the direction of its mean perpendicular (3c).

12. Apparatus according to Claim 11, **characterised in that** the crystallisation tank (3) and/or the inside part (4) is/are circular cylindrical in configuration.

13. Apparatus according to Claim 11 or 12, **characterised in that** the crystallisation tank (3) is fixed and the inside part (4) is rotatable.

14. Apparatus according to one of Claims 11 to 13, **characterised in that** the inside part (4) converges at a lower section in the direction of the centre point of the base (3b) of the crystallisation tank (3).

15. Apparatus according to one of Claims 11 to 14, **characterised in that** on its side remote from the feed tank (9), the crystallisation tank (3) is fitted with a fluid-permeable insert (13) such as a membrane, a diffuser, a filter or similar, adjoining which is a discharge tank (14) with an outlet (15) for discharging the solvent.

16. Apparatus according to Claim 15, **characterised in that** a transport means for continuous discharge of the generated crystals is assigned to the insert (13) arranged on the side of the crystallisation tank (3) remote from the feed tank (9).

17. Apparatus according to one of Claims 11 to 16, **characterised in that** the inside of the crystallisation tank (3) and/or the shell surface of the inside part (4) is/are profiled or provided with a surface roughening.

18. Apparatus according to one of Claims 11 to 16, **characterised in that** the inside of the crystallisation tank (3) and/or the shell surface of the inside part (4) is/are smooth, in particular polished.

19. Apparatus according to one of Claims 11 to 18, **characterised in that** the crystallisation tank (3) and/or the inside part (4) is/are made of metal or metal alloys.

20. Apparatus according to one of Claims 11 to 18, **characterised in that** the crystallisation tank (3) and/or the inside part (4) is/are made of ceramic.

21. Apparatus according to one of Claims 11 to 18, **characterised in that** the crystallisation tank (3) and/or the inside part (4) is/are made of glass.

22. Apparatus according to one of Claims 11 to 18, **characterised in that** the crystallisation tank (3) and/or the inside part (4) is/are made of plastic.

23. Apparatus according to one of Claims 11 to 22, **characterised in that** the crystallisation tank (3) and/or the inside part (4) is/are coated with plastic.

## Revendications

1. Procédé de production de particules de matière solide cristallines régulières (1), ne comportant pas (ou comportant peu) de défauts du cristal tels que vices de matière ou autres, à partir d'au moins une matière solide à solubilité positive dissoute dans un solvant, selon lequel la solution est refroidie jusqu'en dessous de sa température de saturation en formant le produit de cristallisation en matière solide, et celui-ci est séparé,
**caractérisé en ce que**
la solution est refroidie dans un courant de cisaillement laminaire, appelé "courant de Couette".

2. Procédé de production de particules de matière solide cristallines régulières (1), ne comportant pas (ou comportant peu) de défauts du cristal tels que vices de matière ou autres, à partir d'au moins une matière solide à solubilité positive dissoute dans un solvant, selon lequel la solution est réchauffée jusqu'au-dessus de sa température de saturation en formant le produit de cristallisation en matière solide, et celui-ci est séparé,
**caractérisé en ce que**
la solution est réchauffée dans un courant de cisaillement laminaire, appelé "courant de Couette".

3. Procédé selon la revendication 1 ou 2,
**caractérisé en ce que**
la taille des particules du produit de cristallisation en matière solide est réglée par variation de la vitesse de refroidissement ou de réchauffement et/ou par la vitesse d'écoulement du courant de Couette.

4. Procédé selon l'une des revendications 1 à 3,
**caractérisé en ce que**
la solution est refroidie avec une vitesse de refroidissement essentiellement constante, ou encore réchauffée avec une vitesse de réchauffement essentiellement constante.

5. Procédé selon l'une des revendications 1 à 4,
**caractérisé en ce qu'**
il est exécuté par charges.

6. Procédé selon l'une des revendications 1 à 4,
**caractérisé en ce qu'**
au courant de Couette est superposé, en vue de l'exécution continue ou semi-continue du procédé, un courant laminaire de la solution, orthogonal par rapport à lui.

7. Procédé selon l'une des revendications 1 à 6,
en vue de la production de cristaux essentiellement exempts de vices de matière, faits de matières solides thermiquement sensibles.

8. Procédé selon la revendication 7,
en vue de la production de combustibles, d'explosifs et/ou d'oxydants sous forme finement cristallisée.

9. Procédé selon la revendication 7,
en vue de la production de substances actives pharmaceutiques et/ou homéopathiques sous forme finement cristallisée.

10. Procédé selon la revendication 7,
en vue de la production d'hormones et/ou de dérivés d'hormones sous forme finement cristallisée.

11. Dispositif (2) en vue de la production de cristaux (1) à partir d'au moins une matière solide dissoute dans un solvant, en particulier pour l'exécution du procédé selon l'une des revendications 1 à 10,
comportant un réservoir de cristallisation (3) destiné à recevoir la solution, avec un élément intérieur (4) essentiellement cylindrique, disposé coaxialement vis-à-vis du réservoir (3) en formant un espace annulaire radial (7) et pouvant tourner par rapport à ce dernier,
le réservoir de cristallisation (3) et/ou l'élément intérieur (4) pouvant être tempéré,
**caractérisé en ce qu'**
en amont du réservoir de cristallisation (3), dans la direction de sa verticale centrale (3c), un réservoir d'alimentation (9) se trouvant en liaison avec lui, présente une section transversale correspondant à peu près à la section transversale du réservoir de cristallisation (3) et comportant une conduite d'amenée (10) pour la solution, et
est relié avec le réservoir de cristallisation (3) par l'intermédiaire d'une garniture perméable aux fluides (telle qu'une membrane, une fritte, un filtre ou autre objet similaire) et sert à amener au réservoir de cristallisation (3) un courant laminaire (12) orienté dans la direction de sa verticale centrale (3c).

12. Dispositif selon la revendication 11,
**caractérisé en ce que**
le réservoir de cristallisation (3) et/ou l'élément intérieur (4) a une forme cylindrique circulaire.

13. Dispositif selon la revendication 11 ou 12,
**caractérisé en ce que**
le réservoir de cristallisation (3) est stationnaire et l'élément intérieur (4) peut tourner.

14. Dispositif selon l'une des revendications 11 à 13,
**caractérisé en ce que**
l'élément intérieur (4) converge, sur une section inférieure, en direction du centre de la base (3b) du réservoir de cristallisation (3).

15. Dispositif selon l'une des revendications 11 à 14,
**caractérisé en ce que**
le réservoir de cristallisation (3) est muni, sur sa face tournant le dos au réservoir d'alimentation (9), d'une garniture perméable aux fluides (13) (telle qu'une membrane, une fritte, un filtre ou autre objet similaire) à laquelle se raccorde un réservoir d'évacuation (14) comportant une conduite d'écoulement (15) pour l'évacuation du solvant.

16. Dispositif selon la revendication 15,
**caractérisé en ce qu'**
à la garniture (13) disposée sur la face, tournant le dos au réservoir d'alimentation (9), du réservoir de cristallisation (3) est associé un mécanisme de transport pour l'évacuation continue des cristaux produits.

17. Dispositif selon l'une des revendications 11 à 16,
**caractérisé en ce que**
la face intérieure du réservoir de cristallisation (3) et/ou la surface d'enveloppe de l'élément intérieur (4) est profilée ou pourvue d'une rugosité superficielle.

18. Dispositif selon l'une des revendications 11 à 16,
**caractérisé en ce que**
la face intérieure du réservoir de cristallisation (3) et/ou la surface d'enveloppe de l'élément intérieur (4) est constituée de manière lisse, et en particulier polie.

19. Dispositif selon l'une des revendications 11 à 18,
**caractérisé en ce que**
le réservoir de cristallisation (3) et/ou l'élément intérieur (4) est en métal ou en alliage métallique.

20. Dispositif selon l'une des revendications 11 à 18,
**caractérisé en ce que**
le réservoir de cristallisation (3) et/ou l'élément intérieur (4) est en céramique.

21. °) Dispositif selon l'une des revendications 11 à 18,
**caractérisé en ce que**
le réservoir de cristallisation (3) et/ou l'élément intérieur (4) est en verre.

22. Dispositif selon l'une des revendications 11 à 18,
**caractérisé en ce que**
le réservoir de cristallisation (3) et/ou l'élément intérieur (4) est en matière plastique.

23. Dispositif selon l'une des revendications 11 à 22,
**caractérisé en ce que**
le réservoir de cristallisation (3) et/ou l'élément intérieur (4) est revêtu de matière plastique.
